# EUROPEAN PATENT APPLICATION

(11) **EP 4 481 789 A1**
(43) Date of publication of application: **25.12.2024**
(21) Application number: 22926797.6
(22) Date of filing: 09.11.2022
(51) Int. Cl.: H01J 1/06, H01J 1/10, H01J 1/05

(54) **ELECTRON EMISSION APPARATUS AND ELECTRONIC APPARATUS**

(30) Priority: 18.02.2022 CN 202210152727
(71) Applicant: Westlake University, Hangzhou, Zhejiang 310024 (CN)
(72) Inventor: LI, Xijun, Hangzhou, Zhejiang 310024 (CN)
(74) Representative: Petraz, Gilberto Luigi
(86) International application number: PCT/CN2022/130787
(87) International publication number: WO 2023/155493

(57) **Abstract**

Provided in the embodiments of the present disclosure are an electron emission apparatus and an electronic apparatus. The electron emission apparatus comprises a fire-resistant container and a heating power supply, the fire-resistant container being provided with a cavity part, the cavity part having a certain degree of vacuum, an electron emission material being arranged in the cavity part, at least one through hole being formed in the bottom of the fire-resistant container, and after being melted by heating, the electron emission material passing through the through hole so as to have an arc-shaped outwards-convex liquid surface and to emit electrons outwards. The embodiments of the present disclosure have a relatively good electron field emission effect and a high degree of product structure consistency, and achieve easy commissioning. The service life of the electron emission apparatus is in direct proportion to the mass of the accommodated electron emission material, so that the service life of the disclosed electronic apparatus can be remarkably prolonged compared with that of a traditional thermal field emission or cold field emission filament, thereby meeting the use requirements of an electron beam exposure machine, a scanning electron microscope, a transmission electron microscope and other X-ray sources.

## Description

### Technical field

The present disclosure relates to an electron emission source, and in particular, to an electron emission apparatus.

### Background

The electron emission apparatus is an important invention in modern times, and its applications in our daily life comprise a cathode ray tube display and a ray tube which generates X-ray by bombarding a heavy metal with an electron beam generated by itself after the electron beam is accelerated to a high voltage. Although the cathode ray tube display has faded out of our daily life, the X-ray source excited by the electron emission apparatus is still widely used in medical equipment such as chest X-ray and CT for examination. A vacuum electron tube made from the electron emission apparatus still plays a very important role in high frequency and high power microwave technology, such as radar. In scientific research, a scanning electron microscope, a transmission electron microscope and a mass spectrometer are all inseparable from the electron emission apparatus, and the electron beam exposure machine, as the photolithography mask manufacturing equipment in modern chip production technology, is also inseparable from the electron emission apparatus.

The main physical mechanisms of existing electron emission apparatus include photo excitation, thermal excitation, electric field excitation and secondary electron generation or combination thereof. Of these, electron generation technology by photo excitation is mainly used in photomultiplier tube; scanning electron microscope and electron beam exposure technology mainly adopt thermal excitation and electric field excitation technology, especially thermal field emission technology and cold field emission technology. Thermal field emission technology is widely used in electron beam exposure machine, high-end scanning electron microscope and transmission electron microscope because it can output very stable and high electron beam current for a long time. The current thermal field emission electron beam apparatus is a thermal field electron emission filament. When emitting electrons, the filament material is solid, and the strong electric field required for field emission depends on the processing accuracy of the filament tip. Usually, a tungsten single crystal is chemically etched to form a needle tip with a very high height-width ratio, and the radius of the tip is within 100 nm to ensure the strong electric field required for field emission. The disadvantages of such apparatus include: 1) the repeatability of geometry and size of the needle tip processed by chemically etching a tungsten single crystal is poor, the electron emission consistency of processed filament is not high, and the installation and commissioning are troublesome; 2) the filament has a large geometric size, and usually the diameter of the filament for electron microscope is 1-2 cm after assembly, which is difficult to be used to form an array to be installed in an electron microscope or an electron beam exposure machine; 3) the lifetime of the filament is relatively short, generally around 10000 hours; 4) the electron beam flow emitted by the filament is instable or ineffective due to defects, adsorption and the like in the tungsten needle tip after chemical etching; 4) at present, the preparation technology of the needle tip is limited to a few materials such as W and LaB6, which limits the selection range of materials for the electron beam emission apparatus.

### Summary of the invention

In view of this, the embodiments of the present disclosure provide an electron emission apparatus and an electronic apparatus to overcome the disadvantages of lacking of consistency of the existing solid thermal emission or thermal field emission filament products, difficulty in using filaments to form a compact array and short service life, and the like.

The present disclosure provides an electron emission apparatus comprising a fire-resistant container having a cavity part and a heating power supply with a certain degree of vacuum, an electron emission material is provided in the cavity part, at least one through hole is provided at the bottom of the fire-resistant container, and after melting by being heated, the electron emission material passes through the through hole, forming an arc-shaped outwards-convex liquid surface, and emits electrons outwards.

In embodiments, a melting temperature of the fire-resistant container is higher than a melting temperature of the electron emission material and a working temperature of the electron emission apparatus, and the melting temperature of the electron emission material is lower than the working temperature of the electron emission apparatus.

In some embodiments, a cross section of the fire-resistant container is the shape of at least one of a circle, a rectangle, an oblong and an ellipse, and the cavity part is a circular cavity.

In some embodiments, the electron emission material is at least one of a semiconductor material, an electrically insulating material, and a metal material.

In some embodiments, the semiconductor material is GaAs or InP; or the electrically insulating material is at least one of CsO2, Zr2O3, Y2O3, BeO, WO3, Rb2O, Ir2O3; or the metal material is at least one of W, Re, Ru, Pt, and Zr.

In some embodiments, a plurality of the through holes are provided at the bottom of the fire-resistant container, so as to form an electron emission array.

In some embodiments, the electron emission apparatus further comprises a heating device provided on a side wall of the fire-resistant container and used to heat the fire-resistant container and the electron emission material therein.

In some embodiments, a corresponding annular extraction electrode is provided beneath each through hole, and the extraction electrode is provided opposite to the outwards-convex liquid surface.

In some embodiments, the electron emission apparatus further comprises an extraction power supply, a negative electrode of the extraction power supply is connected to the outwards-convex liquid surface of the electron emission material via an inner wall of the fire-resistant container, and a positive electrode of the extraction power supply is connected to the annular extraction electrode.

The present disclosure also provides an electronic apparatus, which adopts the electron emission apparatus in any one of the above technical solutions, and the electronic apparatus at least comprises one of a vacuum electron tube, an X-ray generator, an electronic display and a thermoelectric transducer.

The embodiments of the present disclosure can achieve relatively high electron field emission effect, high degree of product structure consistency, and easy commissioning. The service life of the electron emission structure is in direct proportion to the quality of the electron emission material contained therein, so that the electron generation service life can be significantly prolonged compared to that of the traditional thermal field emission filament and cold field emission filament, meeting the application in electron beam exposure machines, scanning electron microscopes, transmission electron microscopes and other X-ray sources.

### Brief Description of the Drawings

In order to more clearly explain the embodiments of the present disclosure or the technical solutions in the prior art, the accompanying drawings needed in the description of the embodiments or the prior art will be briefly introduced below. Obviously, the accompanying drawings in the following description are only some of the embodiments recorded in the present disclosure, and other accompanying drawings can be obtained according to these accompanying drawings for those skilled in the art without creative work.
FIG. 1 is a schematic structural diagram of an electron emission apparatus according to an embodiment of the present disclosure;
FIG. 2 is a schematic structural diagram of an electron emission apparatus according to an embodiment of the present disclosure;
FIG. 3 is a schematic functional diagram of an electron emission apparatus according to an embodiment of the present disclosure.

### Detailed Embodiments

In order to make the purposes, technical solutions and advantages of the embodiments of the present disclosure clearer, the technical solutions of the embodiments of the present disclosure will be clearly and completely described below with reference to the accompanying drawings of the embodiments of the present disclosure. Obviously, the described embodiments are a part of the embodiments, rather than the entire embodiments, of the present disclosure. Based on the described embodiments of the present disclosure, all other embodiments obtained by those skilled in the art without creative work fall into protection scope of the present disclosure.

Unless otherwise defined, technical terms or scientific terms used in the present disclosure shall have their ordinary meanings as understood by people with ordinary skills in the art to which the present disclosure belongs. The terms "first", "second" and the like used in the present disclosure do not indicate any order, quantity or importance, but are only used to distinguish different components. Similar words such as "comprise" or "contain" mean that the elements or objects appearing before the word cover the listed elements or objects appearing after the word and their equivalents, without excluding other elements or objects. Similar words such as "connection" or "connected" are not limited to physical or mechanical connection, and can comprise electrical connection, whether direct or indirect. "up", "down", "left" and "right" are only used to indicate the relative positional relationship, and when the absolute position of the described object changes, the relative positional relationship may also change accordingly.

In order to keep the following description of the embodiments of the present disclosure clear and concise, the detailed description of known functions and known components is omitted from the present disclosure.

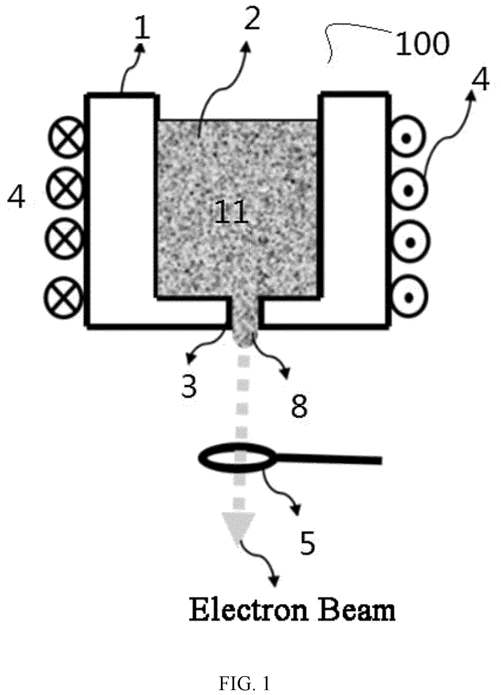

An embodiment of the present disclosure relates to an electron emission apparatus. The electron emission apparatus here is mainly applied to an electron microscopes and electron beam exposure technology, and can also be used in other devices such as vacuum electron tubes, X-ray generators, electronic displays, thermoelectric transducers. As shown in FIG. 1, an embodiment of the present disclosure relates to an electron emission apparatus 100, which can be provided at the top of a scanning electron microscope/electron beam lithography column of a device such as a scanning electron microscope, a transmission electron microscope, an electron beam exposure machine, for example; specifically, the electron emission apparatus 100 comprises a fire-resistant container 1, a cross section of which can be the shape of a circle, and can also be other shapes of a rectangle, an oblong and an ellipse, for example, and the fire-resistant container 1 has a cavity part 11which is a vacuum cavity with a certain degree of vacuum, and the cavity part 11 here can be a circular cavity with an inner diameter ranging from 1 um to 100 um. An electron emission material 2 having a fixed melting temperature is provided in the cavity part 11 of the fire-resistant container 1.

Further, the fire-resistant container 1 here is made of a material with a high melting temperature, such as a metal material. The melting temperature of the material of the fire-resistant container 1 is higher than the melting temperature of the electron emission material 2 and higher than a working temperature of the electron emission apparatus 100, and the melting temperature of the electron emission material 2 is lower than the working temperature of the electron emission apparatus 100. In this way, when the electron emission apparatus 100 works, the electron emission material 2 will melt into liquid state, while the fire-resistant container 1 will not melt. It should be noted that he electron emission material 2 and the material of the fire-resistant container 1 will not produce chemical reaction or form an alloy between room temperature and the melting temperature of the fire-resistant container 1.

Further, the electron emission material 2 here refers to a material that absorbs a certain amount of energy, so that electrons are released from the bindings of atomic nucleus and emitted out of atoms. The electron emission material 2 here can be a semiconductor material, preferably a semiconductor material with low work function, such as GaAs, InP and the like, the energy band gap of which is between 0.2 eV and 5 eV at the room temperature; in addition, the electron emission material 2 can also be an electrically insulating material, preferably an oxide material with low work function, such as CsO2, Zr2O3, Y2O3, BeO, WO3, Rb2O, Ir2O3 and the like; certainly, the electron emission material 2 can also be a metal material, preferably a metal material with low work function, such as W, Re, Ru, Pt, Zr and the like.

Further, at least one through hole 3 is provided at the bottom of the fire-resistant container 1, and the electron emission material 2 emits electrons outwards through the through hole 3. The through hole 3 here is a micron-sized through hole formed by micro-nano processing technology, and the diameter of the through hole 3 is between 0.1 um and 100 um. The micro-nano processing technology allows for a high degree of structure consistency. In another embodiment, a plurality of the through holes 3 can be provided at the bottom of the fire-resistant container 11, so that a formation of an electron emission array can be facilitated.

In addition, the electron emission apparatus 100 further comprises a heating device 4 and a heating power supply 6, wherein the heating device 4 is provided on a side wall of the fire-resistant container 1 for heating the fire-resistant container 1 and the electron emission material 2 therein, and can be a device such as a resistance wire and the like; the heating power supply 6 is connected to the heating device 4 to provide electric energy to heat the electron emission material 2 in the fire-resistant container 1 to its melting temperature or above by means of the heating device 4, and is provided outside the fire-resistant container 1 and regulates the electric energy provided to the heating device 4 by regulating the power, wherein the heating power supply 6 is a constant-voltage DC power supply with an output current between 0 A and 10 A.

In some embodiments, in a case where the fire-resistant container 1 is made of a conductive material, such as a metal material, the heating device 4 may not be provided, and the heating power supply 6 may be directly connected to the outer wall of the fire-resistant container 1, so that the electron emission material 2 in the fire-resistant container 1 can be heated to its melting temperature or above by regulating the power.

As mentioned above, after the electron emission material 2 is heated to its melting temperature or above, the electron emission material 2 will be in a liquid state after melting, and the liquid electron emission material 2 will pass through the through hole 3 due to gravity and the like, forming an arc-shaped outwards-convex liquid surface 8. Specifically, since the working temperature of the electron emission apparatus 100 is higher than the melting temperature of the electron emission material 2, there will be immersional wetting between the liquid and the solid between the melting temperature of the electron emission material 2 and the working temperature of the electron emission apparatus 100, that is, the electron emission material 2 in the liquid state, after passing through the through hole 3 due to the gravity and the like, will form the arc-shaped outwards-convex liquid surface 8 at the opening of the through hole 3.

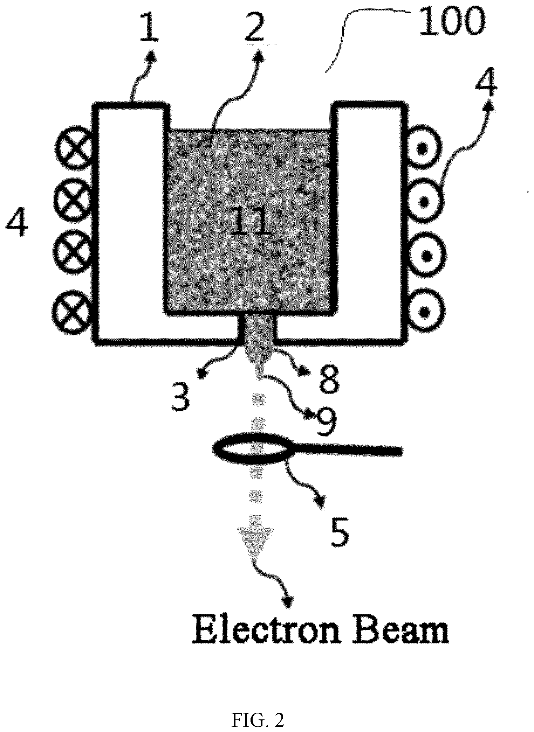

In this way, after the electron emission material 2 reaches the melting temperature, that is, melts after being heated, due to the immersional wetting between the solid and the liquid on the side wall of the through hole 3, the electron emission material 2 in the liquid state, based on the immersional wetting of the side wall of the through hole 3, passes through the through hole 3 of the fire-resistant container 1 due to the gravity or capillary force, and then forms the arc-shaped outwards-convex liquid surface 8, which can emit electron beams under strong electric field, at the opening of the through hole 3; further, as shown in FIG. 2, under high electric field, the outwards-convex liquid surface 8 can further draw a droplet structure with a smaller radius, that is, form a structure of a liquid needle tip 9, so as to further enhance the local electric field and enhance the field emission effect of electrons.

In order to construct an electric field to facilitate the outwards-convex liquid surface 8 to emit electron beams, a corresponding annular extraction electrode 5 is provided beneath each through hole 3, and the extraction electrode 5 is provided opposite to the outwards-convex liquid surface 8, that is, the central axis of the extraction electrode 5 coincides with the symmetry axis of the outwards-convex liquid surface 8. The space between the through hole 3 and the extraction electrode 5 is 50 um to 5000 um; wherein, the extraction electrode 5 has an annular structure with an inner diameter of 1 um to 100 um.

Further, the electron emission apparatus 100 further comprises an extraction power supply 7 which can be provided outside the fire-resistant container 1, a negative electrode of the extraction power supply 7 is connected to the outwards-convex liquid surface 8 of the electron emission material 2 via the inner wall of the fire-resistant container 1, and a positive electrode of the extraction power supply 7 is connected to the annular extraction electrode 5. The extraction power supply 7 is an adjustable DC voltage source with an output voltage between 0 V and 6 kV.

In the embodiments of the present disclosure, the outwards-convex liquid surface can be formed by the cooperation of liquid obtained from melting of the electron emission material and the through hole, and the outwards-convex liquid surface forms a liquid needle tip under a strong DC electric field, so that the selection range of the electron emission material can be extended. The structural service life of such electron emission apparatus is in direct proportion to the mass of the electron emission material contained therein, and thus, the electron emission service life of the electron emission apparatus can be significantly increased compared to that of the traditional thermal field emission filament and cold field emission filament.

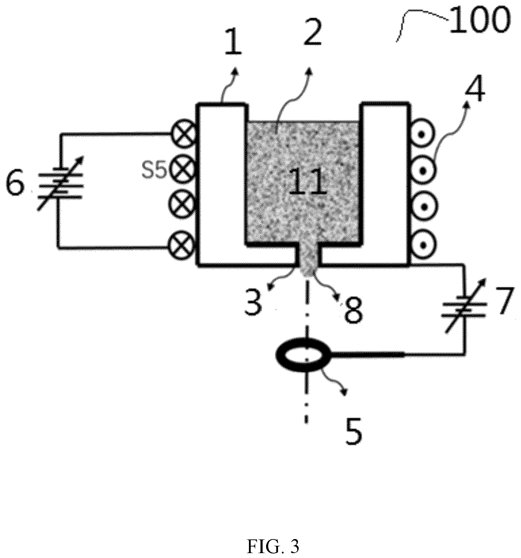

In the process of adopting the electron emission apparatus 100 in the embodiments of the present disclosure, as shown in FIG. 3, it can be implemented in the following ways: in the cases of a scanning electron microscope, a transmission electron microscope and an electron beam exposure machine, the fire-resistant container 1 in the electron emission apparatus 100 is provided at the top of the scanning electron microscope/electron beam lithography column therein, and the electron emission material 2 in the above embodiment is further provided in the cavity part 11 of the fire-resistant container 1, the heating power supply 6 is connected to the heating device 5 and the heating device 5 is connected to the fire-resistant container 1. In a case where the fire-resistant container 1 is made of a metal material, the heating power supply 6 can be directly connected to the fire-resistant container 1.

Further, after the cavity part 11 of the fire-resistant container 1 located at the top of the scanning electron microscope /electron beam lithography column, for example, is evacuated to a high vacuum state, for example, after the degree of vacuum in the cavity part 11 is adjusted to 1 micro Pascal, the power V1 of the heating power supply 6 is regulated until the temperature of the electron emission material 2 reaches the melting temperature, so that the electron emission material 2 begins to melt; then, the power V1 of the heating power supply 6 is gradually increased, until the electron emission material 2 melting to liquid in the fire-resistant container 1 passes through the through hole 3 at the lower end of the fire-resistant container 1 and continuously falls due to the gravity or capillary force, so that a stable arc-shaped outwards-convex liquid surface 8 is formed at the lower end opening of the through hole 3 due to the joint action of the immersional wetting between the electron emission material 2 in liquid state and the through hole 3 in solid state as well as liquid surface energy; then, the voltage of the extraction power supply 7 is gradually increased, so that a strong electric field is formed by the extraction electrode 7, and the outwards-convex liquid surface 8 emits an electron beam under the strong electric field, thereby achieving the purpose of emitting electrons. Certainly, the outwards-convex liquid surface 8 can also form a stable liquid needle tip 9 under the strong electric field and liquid surface energy, and the liquid needle tip 9 can further enhance the local electric field intensity, thereby enhancing the field emission effect of emitting electron beams and achieving the purpose of forming an electron emission apparatus having high-brightness.

In the process of emitting an electron beam by means of the electron emission apparatus, the capillary action of liquid, the structure of micron-scale capillary tubes, the immersional wetting of materials, the electric field effect and the like are adopted, so that the electron field emission effect is relatively high, the degree of structure consistency is relatively high, and the commissioning is easy; the service life of the electron emission structure is in direct proportion to the mass of the electron emission material contained therein, so that the electron generation service life can be significantly prolonged compared to that of the traditional thermal field emission filament and cold field emission filament.

An embodiment of the present disclosure also provides an electronic apparatus, which adopts the electron emission apparatus in any one of the above technical solutions, and the electronic apparatus here at least comprises one of a vacuum electron tube, an X-ray generator, an electronic display and a thermoelectric transducer.

The above description is only the preferred embodiments of the present disclosure and the explanation of the applied technical principles. It should be understood by those skilled in the art that the disclosure scope involved in the present disclosure is not limited to the technical solution formed by the specific combination of the above technical features, but also covers other technical solutions formed by any combination of the above technical features or their equivalent features without departing from the above disclosure concept. For example, the above features and technical features with similar functions disclosed in the present disclosure, but not limited to, can be replaced with each other to form a technical solution.

Furthermore, although operations are depicted in a specific order, this should not be understood as requiring that these operations be performed in the specific order shown or in a sequential order. Under certain circumstances, multitasking and parallel processing may be beneficial. Likewise, although several specific implementation details are contained in the above discussion, these should not be construed as limiting the scope of the present disclosure. Some features described in the context of individual embodiment can also be combined in a single embodiment. On the contrary, various features described in the context of a single embodiment can also be implemented in multiple embodiments individually or in any suitable sub-combination.

Although the subject matter has been described in language specific to structural features and/or methodological logical actions, it should be understood that the subject matter defined in the appended claims is not necessarily limited to the specific features or actions described above. On the contrary, the specific features and actions described above are only exemplary forms for implementing the claims.

Although a plurality of embodiments of the present disclosure have been described in detail above, the present disclosure is not limited to these specific embodiments. Those skilled in the art can make various variations and modifications to the embodiments based on the concepts of the present disclosure. These variations and modifications all should fall within the scope of protection claimed by the present disclosure.

## Claims

1. An electron emission apparatus, which comprises a fire-resistant container having a cavity part and a heating power supply with a certain degree of vacuum, **characterized in that** an electron emission material is provided in the cavity part, at least one through hole is provided at the bottom of the fire-resistant container, and after melting by being heated, the electron emission material passes through the through hole to form an arc-shaped outwards-convex liquid surface, and emits electrons outwards.

2. The electron emission apparatus according to claim 1, **characterized in that** a melting temperature of the fire-resistant container is higher than a melting temperature of the electron emission material and a working temperature of the electron emission apparatus, and the melting temperature of the electron emission material is lower than the working temperature of the electron emission apparatus.

3. The electron emission apparatus according to claim 1, **characterized in that** a cross section of the fire-resistant container is the shape of at least one of a circle, a rectangle, an oblong and an ellipse, and the cavity part is a circular cavity.

4. The electron emission apparatus according to claim 1, **characterized in that** the electron emission material is at least one of a semiconductor material, an electrically insulating material, and a metal material.

5. The electron emission apparatus according to claim 4, **characterized in that** the semiconductor material is GaAs or InP; or the electrically insulating material is at least one of CsO2, Zr2O3, Y2O3, BeO, WO3, Rb2O, Ir2O3; or the metal material is at least one of W, Re, Ru, Pt, and Zr.

6. The electron emission apparatus according to claim 1, **characterized in that** a plurality of the through holes are provided at the bottom of the fire-resistant container, so as to form an electron emission array.

7. The electron emission apparatus according to claim 1, **characterized in that** further comprising a heating device provided on a side wall of the fire-resistant container and used to heat the fire-resistant container and the electron emission material therein.

8. The electron emission apparatus according to claim 1, **characterized in that** a corresponding annular extraction electrode is provided beneath each through hole, and the extraction electrode is provided opposite to the outwards-convex liquid surface.

9. The electron emission apparatus according to claim 8, **characterized in that** further comprising an extraction power supply, a negative electrode of the extraction power supply being connected to the outwards-convex liquid surface of the electron emission material via an inner wall of the fire-resistant container, and a positive electrode of the extraction power supply being connected to the annular extraction electrode.

10. An electronic apparatus, **characterized in that** the electron emission apparatus according to any one of the preceding claims is adopted, and the electronic apparatus at least comprises one of a vacuum electron tube, an X-ray generator, an electronic display and a thermoelectric transducer.
